# EUROPEAN PATENT APPLICATION

(11) **EP 4 009 506 A1**
(43) Date of publication of application: **08.06.2022**
(21) Application number: 20212092.9
(22) Date of filing: 07.12.2020
(51) Int. Cl.: H02M 3/335, H05B 45/385, H05B 45/382, H02M 1/40, G01R 15/18

(54) **SYNCHRONOUS CONVERTER AND LIGHTING SYSTEM COMPRISING THE SAME**

(71) Applicant: Tridonic GmbH & Co. KG, 6851 Dornbirn (AT)
(72) Inventor: Lochmann, Frank, 6850 Dornbirn (AT)
(74) Representative: Rupp, Christian

(57) **Abstract**

A synchronous, primary-side switched and isolated converter (1) with output terminals (101) for driving LED lighting means (102) is disclosed. The synchronous converter comprises: a transformer (103, 104) configured to couple a primary side (105) and a secondary side (106) of the synchronous converter (1); and at least one switch (107) on the primary side (105). The secondary side (106) comprises a current sensing transformer (108 -110) for sensing an indication of a load current (112) induced in the LED lighting means (102) when connected to the output terminals (101). The current sensing transformer (108 -110) comprises a bifilar primary winding (108, 109). A first filament (108) of the bifilar primary winding (108, 109) is configured to conduct a secondary side current (111) induced in a secondary winding (104) of the transformer (103, 104) connected to the secondary side (106). A second filament (109) of the bifilar primary winding (108, 109) is configured to conduct the load current (112). The first and second filaments (108, 109) are configured to induce mutually opposing magnetic fluxes in the current sensing transformer (108 - 110). As a result, galvanic isolation and highly accurate sensing may be achieved at low cost.

## Description

### Technical Field

The present invention relates to a synchronous converter, and in particular, to a synchronous converter for lighting systems.

### Background Art

Exemplary switched-mode power converters typically regulate an electrical quantity at their output terminals, such as a load current, in accordance with a signal that is sensed at the respective output. Given a galvanic insulation between the input and output terminals for safety and/or statutory reasons, it may be required to transfer the sensed signal via the galvanic insulation to a controller. Using opto-isolators (a.k.a. opto-couplers) in this connection may be cost-prohibitive, whereas deploying exemplary current sensing transformers may result in sensing inaccuracies due to direct current (DC) offsets.

### Summary of the Invention

The object of the present invention is to provide a synchronous converter capable of solving this and other problems of the prior art.

The invention is defined by the appended independent claims. Preferred embodiments are set forth in the dependent claims and in the following description and drawings.

According to a first aspect of the present disclosure, a synchronous, primary-side switched and isolated converter with output terminals for driving LED lighting means is provided. The synchronous converter comprises: a transformer configured to couple a primary side and a secondary side of the synchronous converter; and at least one switch on the primary side. The secondary side comprises a current sensing transformer for sensing an indication of a load current induced in the LED lighting means when connected to the output terminals. The current sensing transformer comprises a bifilar primary winding. A first filament of the bifilar primary winding is configured to conduct a secondary side current induced in a secondary winding of the transformer connected to the secondary side. A second filament of the bifilar primary winding is configured to conduct the load current. The first and second filaments are configured to induce mutually opposing magnetic fluxes in the current sensing transformer.

The synchronous converter may comprise a synchronous flyback converter. This ensures a galvanic isolation between the primary side and secondary side, and allows for a wide range of applications.

The current sensing transformer may further comprise a secondary sense winding providing a current sense current in dependence of the secondary side current and the load current.

The synchronous converter may further comprise a sample-and-hold circuit for sampling a current sense voltage indicative of the current sense current during a secondary side non-conduction period of a switch of the secondary side.

A polarity of the secondary sense winding may be arranged to provide a positive current sense current during the secondary side non-conduction period.

The synchronous converter may further comprise a shunt circuit for sensing a voltage indicative of a primary side current fed into a primary winding of the transformer connected to the primary side. The sample-and-hold circuit is configured to sample synchronously to zero-crossings of the primary side current.

The sample-and-hold circuit is configured to sample at or within a predetermined time period of zero-crossings of the primary side current.

The synchronous converter may further comprise a controller configured for a feedback control of a mean value of the load current in accordance with the samples of the current sense voltage, by controlling a switching operation of the at least one switch on the primary side.

The controller may be subject to an electric potential of the primary side of the converter.

According to a second aspect, a lighting system is provided, comprising: an synchronous converter according to the first aspect or any of its embodiments, and LED lighting means configured to be supplied by the synchronous converter.

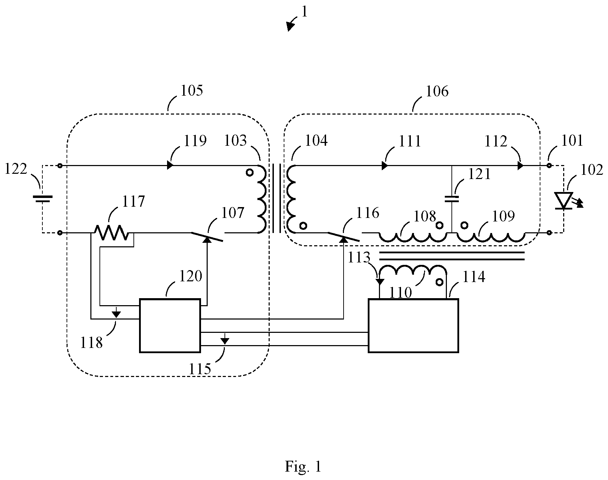

The present disclosure provides a synchronous converter and a lighting system which, by deploying a current sensing transformer with a counter-wound bifilar primary winding, may partially compensate a magnetic flux induced by the secondary side current in the first filament of the bifilar primary winding with a magnetic flux induced by the load current in the second filament of the bifilar primary winding. As the smoothing capacitor (see Fig. 1) effectively blocks DC, a DC component of the secondary side current substantially corresponds to a DC component of the load current. Hence, the current sensing transformer may transfer substantially an AC component of the secondary side current to its secondary sense winding. This avoids a saturation of the ferrite material of the core of the current sensing transformer by a substantial DC component in the current conducted by the primary winding, which DC component may give rise to sensing inaccuracies due to DC offsets. As a result, galvanic isolation and highly accurate sensing may be achieved at low cost.

### Brief Description of the Drawings

Further aspects, advantages and objects of the invention will become evident for the skilled reader by means of the following detailed description of the embodiments of the invention, when taking into conjunction with the figures of the enclosed drawings.
Fig. 1 illustrates a synchronous converter and a lighting system according to embodiments of the present disclosure.
Fig. 2 illustrates a timing of a sampling of a current sense voltage indicative of the current sense current.

### Detailed Descriptions of Embodiments

The invention will now be described with respect to various embodiments. The features of these embodiments may be combined with each other unless specified otherwise.

Fig. 1 illustrates a synchronous converter 1 and a lighting system 1, 102 according to embodiments of the present disclosure.

The synchronous converter 1 is primary-side switched, isolated and provided with output terminals 101 for driving LED lighting means 102. The lighting system 1, 102 is formed by a combination of the synchronous converter 1 and such LED lighting means 102, which are configured to be supplied by the synchronous converter 1.

Fig. 1 shows that the synchronous converter 1 comprises a transformer 103, 104 configured to couple a primary side 105 and a secondary side 106 of the synchronous converter 1. The primary and secondary sides 105, 106 are indicated by rounded boxes having dashed lines.

Primary and secondary sides as used herein may refer to different electric potentials that are isolated from one another galvanically and coupled with one another magnetically.

In particular, the synchronous converter 1 may comprise a synchronous flyback converter.

A flyback converter as used herein may refer to a switched-mode power converter of buck-boost converter type with galvanic isolation between its input and output terminals.

The primary side 105 comprises at least one switch 107 configured to enable or disable a flow of a primary side current 119 from a DC power source 122 connectable to the primary side 105 into a primary winding 103 of the transformer 103, 104.

A switch as used herein may refer to a solid-state power switch, such as a Metal-Oxide Semiconductor Field-Effect Transistor (MOSFET) or an Insulated Gate Bipolar Transistor (IGBT).

Those skilled in the art will appreciate that synchronous converters as the one illustrated in Fig. 1 are further provided with a switch 116 on the secondary side 106 which may replace a rectifying diode and may be off / open / non-conductive when the at least one switch 107 of the primary side 105 is on / closed / conductive, and vice versa. In other words, the switches 107, 116 have non-overlapping ON-periods in order to alternatingly store energy in and retrieve energy from a magnetic field in a core of the transformer 103, 104. Fig. 1 shows that an operation of the switch 116 on the secondary side 106 may be controlled by the controller 120, although other configurations are conceivable as well.

In any event, the switch 116 may be configured to enable or disable a flow of a secondary side current 111 induced in a secondary winding 104 of the transformer 103, 104 connected to the secondary side 106.

The secondary side 106 may comprise a smoothing capacitor 121 for smoothing the secondary side current 111, and for supplying a smoothed load current 112 induced in the LED lighting means 102 when connected to the output terminals 101 even in periods in which no secondary side current 111 is induced in the secondary winding 104.

According to Fig. 1, the secondary side 106 further comprises a current sensing transformer 108 - 110 for sensing an indication of the load current 112. The current sensing transformer 108 -110 comprises a bifilar primary winding 108, 109. A first filament 108 of the bifilar primary winding 108, 109 is configured to conduct the secondary side current 111, and a second filament 109 of the bifilar primary winding 108, 109 is configured to conduct the load current 112. The first and second filaments 108, 109 are configured to induce mutually opposing magnetic fluxes in the current sensing transformer 108 -110. In other words, the bifilar primary winding 108, 109 is counter-wound, as may be taken from Fig. 1 by noting that the primary windings 108, 109 have opposite directions of magnetic flux.

A current sensing transformer as used herein may refer to a transformer configured to convert a high primary current to be measured into a smaller secondary sensing current, based on Faraday's law of induction. Current sensing transformer provide an intrinsic galvanic insolation between the current to be measured and the sensing current. Being a passive device, no extra driving circuitry and little power are needed.

An indication as used herein may refer to a sensed quantity that may serve to indicate a quantity to be measured. In other words, the sensed quantity is a function of the quantity to be measured.

Bifilar as used herein may refer to involving two elementary wires.

A filament as used herein may refer to any elementary wire of a bifilar wire.

According to Fig. 1, the current sensing transformer 108 -110 may further comprise a secondary sense winding 110 for providing a current sense current 113 in dependence of the secondary side current 111 and the load current 112.

As mentioned above, a magnetic flux induced by the secondary side current in the first filament 108 of the bifilar primary winding 108, 109 may partially be compensated by a magnetic flux induced by the load current 112 in the second filament 109 of the bifilar primary winding 108, 109. As a DC component of the secondary side current 111 substantially corresponds to a DC component of the load current 112, the current sensing transformer 108 -110 may transfer substantially the AC component of the secondary side current 111 to its secondary sense winding 110.

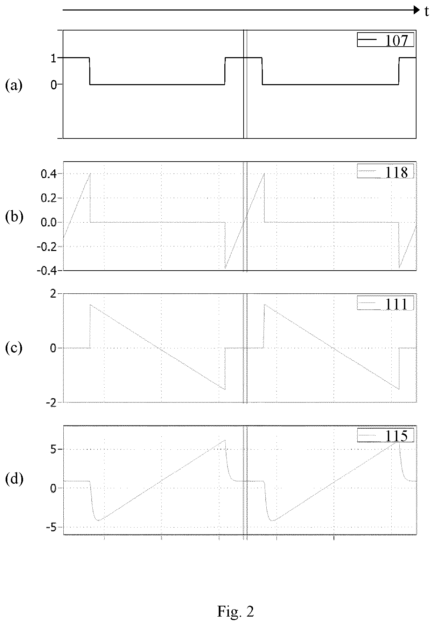

According to Fig. 1, the synchronous converter 1 may further comprise a sample-and-hold circuit 114 for sampling a current sense voltage 115, v_{cs} indicative of the current sense current 113. Details on a timing of the sampling will be explained in connection with Fig. 2. below.

Those skilled in the art will appreciate that sampled values may be passed on as digital values. In Fig. 1, a transfer of the current sense voltage 115, v_{cs} as analog values is indicated for descriptive reasons (i.e., in order to depict the current sense voltage 115, v_{cs} as).

Those skilled in the art will further appreciate that there is a degree of freedom regarding a polarity of the secondary sense winding 110 with respect to the corresponding electrical terminals of the sample-and-hold circuit 114. In particular, a polarity of the secondary sense winding 110 may be arranged to provide a positive current sense current 113 during periods in which the secondary side 106 does not carry any secondary side current 111.

According to Fig. 1, the synchronous converter 1 may further comprise, on its primary side 105, a shunt circuit 117 for sensing a voltage 118, vₛₕᵤₙₜ indicative of a primary side current 119 fed into a primary winding 103 of the transformer 103, 104 connected to the primary side 105.

A shunt as used herein may refer to a device configured to establish a low-resistance path for electric current, such as a shunt resistor.

The sample-and-hold circuit 114 may be configured to perform sampling in accordance with the primary side current 119, as will also be explained in connection with Fig. 2. below.

A sample-and-hold circuit as used herein may refer to a device configured to sample an electrical quantity, such as a voltage, of an analog signal and to hold the sampled value constant for a specified minimum period of time.

According to Fig. 1, the synchronous converter 1 may further comprise, on its primary side 105, a controller 120 configured for a feedback control of a mean value of the load current 112 in accordance with the sampled current sense voltage 115, v_{cs}, by controlling a switching operation of the at least one switch 107 on the primary side 105.

In particular, the controller 120 may be subject to an electric potential of the primary side 105 of the converter 1. In other words, a ground potential of the controller 120 may correspond to a ground potential of the primary side 105. Depending on the desired application of the synchronous converter 1, this may require a galvanic isolation of the sample-and-hold circuit 114 connected to the controller 120 from an electric potential of the secondary side 106. This may be achieved by deploying the current sensing transformer 108 -110.

Fig. 2 illustrates a timing of a sampling of a current sense voltage 115, v_{cs} indicative of the current sense current 113, i_{cs}.

According to Fig. 2(a), a pulse width modulation (PWM) drive signal may be applied to the at least one switch 107 on the primary side 105 of the synchronous converter 1 of Fig. 1. For example, the PWM drive signal may be applied to a gate of a MOSFET switch 107.

According to Fig. 2(b), ON-periods of the drive signal shown in Fig. 2(a) consistently coincide with flows of the primary side current 119 into the primary winding 103 of the transformer 103, 104, as is measured by the voltage 118, vₛₕᵤₙₜ indicative of the primary side current 119. At a beginning of the respective ON-period, the primary side current 119 sharply drops to a negative peak owing to a persisting magnetic flux in the transformer 103, 104, as the at least one switch 107 on the primary side 105 becomes conductive. At an end of the respective ON-period, the primary side current 119 sharply drops from a positive peak as the at least one switch 107 on the primary side 105 becomes non-conductive. At some point within the respective ON-period, the primary side current 119 crosses from negative to positive currents. Such events may be termed 'zero-crossings'.

As mentioned above, the at least one switch 107 on the primary side 105 and the switch 116 on the secondary side 106 have non-overlapping ON-periods. That is to say, during an ON-period of the at least one switch 107 on the primary side 105, the switch 116 on the secondary side 106 is in an OFF-period and vice versa. Accordingly, a zero-crossing of the primary side current 119 shown in Fig. 2(b) may be used as an easily detectable indication of an OFF-period of the switch 116 on the secondary side 106.

According to Fig. 2(c), ON-periods of the drive signal shown in Fig. 2(a) consistently coincide with no conduction of any secondary side current 111 on the secondary side 106 or, in other words, with secondary side non-conduction periods of the switch 116 of the secondary side 106.

Fig. 2(d) illustrates the current sense voltage 115, v_{cs} indicative of the current sense current 113 provided by the current sensing transformer 108 -110 in dependence of the secondary side current 111 and the load current 112.

As mentioned above, a magnetic flux induced by the secondary side current in the first filament 108 of the bifilar primary winding 108, 109 may partially be compensated by a magnetic flux induced by the load current 112 in the second filament 109 of the bifilar primary winding 108, 109. As a DC component of the secondary side current 111 may substantially correspond to a DC component of the load current 112, the current sensing transformer 108 -110 may transfer substantially an AC component of the secondary side current 111 to its secondary sense winding 110. That is to say,
the current sense voltage 115, v_{cs} is indicative of the current sense current 113, and the current sense current 113 is in turn indicative of the AC component of the secondary side current 111.

As may be taken from Fig. 2(d), a polarity of the secondary sense winding 110 has been arranged appropriately to provide a positive current sense current 113 during the above-mentioned secondary side non-conduction period.

Accordingly, an average (i.e., mean value) of the AC component of the secondary side current 111 may be sampled during said secondary side non-conduction period of the switch 116 of the secondary side 106. To this end, the sample-and-hold circuit 114 may be configured to sample synchronously to zero-crossings of the primary side current 119 (see Fig. 2(b)).

More specifically, the sample-and-hold circuit 114 may be configured to sample at or within a predetermined time period of zero-crossings of the primary side current 119. For example, the predetermined time period may comprise 100%, preferably 50% and most preferably 10% of the respective ON-period of the drive signal shown in Fig. 2(a).

## Claims

1. A synchronous, primary-side switched and isolated converter (1) with output terminals (101) for driving LED lighting means (102), comprising:
a transformer (103, 104) configured to couple a primary side (105) and a secondary side (106) of the synchronous converter (1); and
at least one switch (107) on the primary side (105);
wherein the secondary side (106) comprises a current sensing transformer (108, 109, 110) for sensing an indication of a load current (112) induced in the LED lighting means (102) when connected to the output terminals (101);
wherein the current sensing transformer (108, 109, 110) comprises a bifilar primary winding (108, 109);
wherein a first filament (108) of the bifilar primary winding (108, 109) is configured to conduct a secondary side current (111) induced in a secondary winding (104) of the transformer (103, 104) connected to the secondary side (106);
wherein a second filament (109) of the bifilar primary winding (108, 109) is configured to conduct the load current (112); and
wherein the first and second filaments (108, 109) are configured to induce mutually opposing magnetic fluxes in the current sensing transformer (108, 109, 110).

2. The synchronous converter (1) of claim 1,
wherein the synchronous converter (1) comprises a synchronous flyback converter.

3. The synchronous converter (1) of any of the preceding claims,
wherein the current sensing transformer (108, 109, 110) further comprises a secondary sense winding (110) providing a current sense current (113) in dependence of the secondary side current (111) and the load current (112).

4. The synchronous converter (1) of claim 3, further comprising
a sample-and-hold circuit (114) for sampling a current sense voltage (115, vcs) indicative of the current sense current (113) during a secondary side non-conduction period of a switch (116) of the secondary side (106).

5. The synchronous converter (1) of claim 4,
wherein a polarity of the secondary sense winding (110) is arranged to provide a positive current sense current (113) during the secondary side non-conduction period.

6. The synchronous converter (1) of claim 4 or claim 5, further comprising
a shunt circuit (117) for sensing a voltage (118, vₛₕᵤₙₜ) indicative of a primary side current (119) fed into a primary winding (103) of the transformer (103, 104) connected to the primary side (105); and
wherein the sample-and-hold circuit (114) is configured to sample synchronously to zero-crossings of the primary side current (119).

7. The synchronous converter (1) of claim 6,
wherein the sample-and-hold circuit (114) is configured to sample at or within a predetermined time period of zero-crossings of the primary side current (119).

8. The synchronous converter (1) of any of the claims 4 to 7, further comprising
a controller (120) configured for a feedback control of a mean value of the load current (112) in accordance with the samples of the current sense voltage (115, v_{CS}), by controlling a switching operation of the at least one switch (107) on the primary side (105).

9. The synchronous converter (1) of claim 8,
wherein the controller (120) is subject to an electric potential of the primary side (105) of the converter (1).

10. A lighting system (3), comprising:
an synchronous converter (1) of any of the claims 1 to 9, and
LED lighting means (102) configured to be supplied by the synchronous converter (1).
